(19) Europäisches Patentamt
European Patent Office
Office européen des brevets

(11) EP 2 927 296 A1

(12) EUROPEAN PATENT APPLICATION
published in accordance with Art. 153(4) EPC

(43) Date of publication:
**07.10.2015 Bulletin 2015/41**

(21) Application number: **13858271.3**

(22) Date of filing: **29.11.2013**

(51) Int Cl.:
***C09J 113/00*** *(2006.01)* ***C09J 7/02*** *(2006.01)*
***C09J 123/20*** *(2006.01)* ***H01L 21/56*** *(2006.01)*
***H01L 51/50*** *(2006.01)* ***H05B 33/04*** *(2006.01)*

(86) International application number:
**PCT/JP2013/082171**

(87) International publication number:
**WO 2014/084350 (05.06.2014 Gazette 2014/23)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **30.11.2012 JP 2012263792**

(71) Applicant: **LINTEC Corporation**
**Tokyo 173-0001 (JP)**

(72) Inventors:
- **NISHIJIMA Kenta**
  **Tokyo 173-0001 (JP)**
- **NAGANAWA Satoshi**
  **Tokyo 173-0001 (JP)**
- **FUCHI Emi**
  **Tokyo 173-0001 (JP)**

(74) Representative: **Adam, Holger**
**Kraus & Weisert**
**Patentanwälte PartGmbB**
**Thomas-Wimmer-Ring 15**
**80539 München (DE)**

# (54) ADHESIVE AGENT COMPOSITION, ADHESIVE SHEET, AND ELECTRONIC DEVICE

(57) The present invention provides an adhesive composition comprising a diene-based rubber (A) that includes a carboxylic acid-based functional group, and a crosslinking agent (B), an adhesive layer having a thickness of 60 μm that is obtained by crosslinking the adhesive composition having a water vapor transmission rate at a temperature of 40°C and a relative humidity of 90% of 60 g/(m$^2$·day) or less; an adhesive sheet comprising an adhesive layer that is formed using the adhesive composition; and an electronic device comprising a sealing material, the sealing material being formed using the adhesive composition, or the adhesive sheet. According to the present invention, provided are; an adhesive composition that is useful as a material for forming an adhesive layer that exhibits an excellent water barrier capability, and exhibits adhesion and holding power in a well-balanced manner; an adhesive sheet that includes an adhesive layer that is formed using the adhesive composition; and an electronic device that includes a sealing material that is formed using the adhesive composition or the adhesive sheet.

EP 2 927 296 A1

## Description

TECHNICAL FIELD

The present invention relates to an adhesive composition that is useful as a material for forming an adhesive layer that exhibits an excellent water barrier capability (water-blocking capability), and exhibits adhesion and holding power in a well-balanced manner, an adhesive sheet that includes an adhesive layer that is formed using the adhesive composition, and an electronic device that includes a sealing material that is formed using the adhesive composition or the adhesive sheet.

BACKGROUND ART

In recent years, an organic EL device has attracted attention as a light-emitting device that can emit light with high luminance through low-voltage DC drive.
However, the organic EL device has a problem in that emission properties (e.g., luminance, luminous efficiency, and luminous uniformity) easily deteriorate with the passage of time.
It is considered that a deterioration in emission properties occurs when oxygen, water, and the like enter the organic EL device, and cause the electrode and the organic layer to deteriorate. Methods that utilize a sealing material have been proposed in order to solve this problem.
For example, Patent Document 1 discloses an organic EL device having a configuration in which a photocurable resin layer (sealing material) having humidity resistance covers an organic EL layer that is provided on a glass substrate and placed between a transparent electrode and a bottom electrode that are formed in the shape of a thin film. Patent Document 2 discloses a method that seals an organic EL device using a sealing film that is formed using a moisture-proof polymer film and an adhesive layer.
An acrylic-based adhesive and an acrylic-based pressure-sensitive adhesive (hereinafter referred to as "acrylic-based adhesive and the like") have been proposed as an adhesive and a pressure-sensitive adhesive that are used as the sealing material for the organic EL device, taking account of optical properties such as transparency.
For example, Patent Document 3 discloses a UV-curable acrylic-based adhesive that can be cured at room temperature as a sealing material for an organic EL display.
Patent Document 4 discloses an acrylic-based pressure-sensitive adhesive as a pressure-sensitive adhesive that can form a pressure-sensitive adhesive layer that maintains transparency even when subjected to a heat treatment and a drying treatment that are performed when producing the organic EL device in order to remove water and the like.
However, a sealing material that is formed using the acrylic-based adhesive and the like has an insufficient water barrier capability, and is not suitable as a sealing material for which a very high water barrier capability is required (e.g., the sealing material for the organic EL device).
When a sealing material that is formed using the acrylic-based adhesive and the like has a crosslinked structure, the sealing material may be easily delaminated from the adherend due to an impact, vibrations, heat, or the like, and the water barrier capability may deteriorate to a large extent.
In recent years, an adhesive that includes a polyisobutylene-based resin has been proposed as a sealing adhesive that exhibits a good water barrier capability.
For example, Patent Document 5 discloses an adhesive composition that is used as a sealing material for an organic EL display, and includes a specific hydrogenated cycloolefin-based polymer and a polyisobutylene resin.

RELATED-ART DOCUMENT

PATENT DOCUMENT

Patent Document 1: JP-A-5-182759
Patent Document 2: JP-A-5-101884
Patent Document 3: JP-A-2004-87153
Patent Document 4: JP-A-2004-224991
Patent Document 5: JP-T-2009-524705 (WO2007/0087281)

## SUMMARY OF THE INVENTION

### TECHNICAL PROBLEM

A sealing material obtained using the adhesive composition disclosed in Patent Document 5 exhibits a good water barrier capability as compared with a sealing material obtained using an acrylic-based adhesive. However, the water barrier capability of the sealing material obtained using the adhesive composition disclosed in Patent Document 5 is insufficient when it is used as a sealing material for the organic EL device or the like. Moreover, since the balance between adhesion and holding power is poor, the sealing material may come off from the adherend, or may be delaminated from the adherend, due to heat or vibrations that occur when the device is driven, whereby the water barrier capability may deteriorate to a large extent.

The invention was conceived in view of the above situation. An object of the invention is to provide an adhesive composition that is useful as a material for forming an adhesive layer that exhibits an excellent water barrier capability, and exhibits adhesion and holding power in a well-balanced manner, an adhesive sheet that includes an adhesive layer that is formed using the adhesive composition, and an electronic device that includes a sealing material that is formed using the adhesive composition or the adhesive sheet.

### SOLUTION TO PROBLEM

The inventors of the invention conducted extensive studies in order to solve the above problem. As a result, the inventors found that an adhesive layer that exhibits sufficient cohesive strength and an excellent water barrier capability, and exhibits adhesion and holding power in a well-balanced manner, can be obtained by utilizing an adhesive composition that includes a diene-based rubber that includes a carboxylic acid-based functional group, and a crosslinking agent. This finding has led to the completion of the invention.

Several aspects of the invention provide the following adhesive composition (see (1) to (5)), adhesive sheet (see (6) to (9)), and electronic device (see (10)).

(1) An adhesive composition including a diene-based rubber (A) that includes a carboxylic acid-based functional group, and a crosslinking agent (B), an adhesive layer having a thickness of 60 μm that is obtained by crosslinking the adhesive composition having a water vapor transmission rate at a temperature of 40°C and a relative humidity of 90% of 60 g/($m^2$·day) or less.

(2) The adhesive composition according to (1), wherein the diene-based rubber (A) is a polyisoprene-based rubber that includes a carboxylic acid-based functional group.

(3) The adhesive composition according to (1), wherein the diene-based rubber (A) includes a polymer that includes a repeating unit represented by the following formula (I) and a repeating unit represented by the following formula (II),

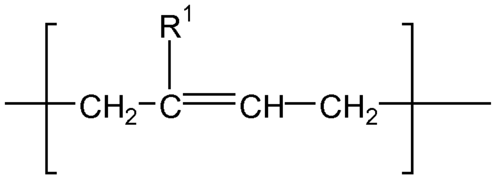

(I)

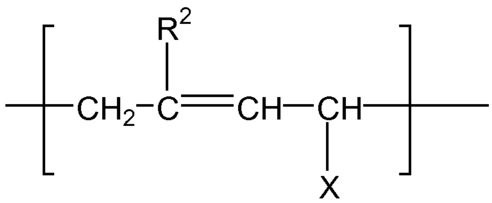

(II)

wherein $R^1$ and $R^2$ are a hydrogen atom or an alkyl group having 1 to 5 carbon atoms, X is a group represented by the following formula (III) or (IV),

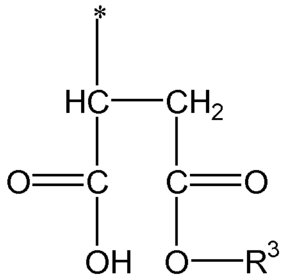

(III)

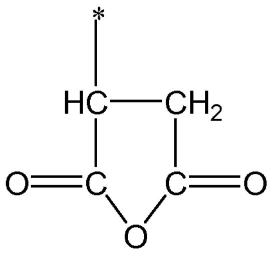

(IV)

$R^3$ is a hydrogen atom or an alkyl group having 1 to 5 carbon atoms, and "*" is a bonding position.

(4) The adhesive composition according to (1), wherein the diene-based rubber (A) has a number average molecular weight (Mn) of 1000 to 100,000.

(5) The adhesive composition according to (1), wherein the average number of carboxylic acid-based functional groups per molecule of the diene-based rubber (A) is 1.5 to 20.

(6) The adhesive composition according to (1), wherein the crosslinking agent (B) is an epoxy-based crosslinking agent.

(7) The adhesive composition according to (1), further including a rubber-based polymer (C) that does not include a carboxylic acid-based functional group.

(8) The adhesive composition according to (7), wherein the rubber-based polymer (C) that does not include a carboxylic acid-based functional group is an isobutylene-based polymer.

(9) The adhesive composition according to (1), further including a tackifier (D). [0014]

(10) An adhesive sheet including an adhesive layer that is formed using the adhesive composition according to any one of (1) to (9), and a release sheet that is provided on one side or each side of the adhesive layer.

(11) An adhesive sheet including an adhesive layer that is formed using the adhesive composition according to any one of (1) to (9), and a base sheet.

(12) The adhesive sheet according to (10) or (11), wherein the adhesive layer is formed by a reaction between the diene-based rubber (A) and the crosslinking agent (B).

(13) The adhesive sheet according to (10) or (11), the adhesive sheet being used to form a sealing material for an electronic device.

(14) An electronic device including a sealing material, the sealing material being formed using the adhesive composition according to any one of (1) to (9), or the adhesive sheet according to (13).

## ADVANTAGEOUS EFFECTS OF THE INVENTION

The aspects of the invention thus provide an adhesive composition that is useful as a material for forming an adhesive layer that exhibits an excellent water barrier capability, and exhibits adhesion and holding power in a well-balanced manner, an adhesive sheet that includes an adhesive layer that is formed using the adhesive composition, and an electronic device that includes a sealing material that is formed using the adhesive composition.

## BRIEF DESCRIPTION OF DRAWINGS

FIG. 1 is a view illustrating an example of the layer configuration of an adhesive sheet according to one embodiment of the invention.

FIG. 2 is a view illustrating an example of the layer configuration of an adhesive sheet according to one embodiment of the invention.

FIG. 3 is a view illustrating an example of an electronic device according to one embodiment of the invention.

DESCRIPTION OF EMBODIMENTS

An adhesive composition, an adhesive sheet, and an electronic device according to several exemplary embodiments of the invention are described in detail below.

1) Adhesive composition

An adhesive composition according to one embodiment of the invention includes a diene-based rubber (A) that includes a carboxylic acid-based functional group, and a crosslinking agent (B), an adhesive layer having a thickness of 60 μm that is obtained by crosslinking the adhesive composition having a water vapor transmission rate at a temperature of 40°C and a relative humidity of 90% of 60 g/($m^2$·day) or less.

Diene-based rubber (A) that includes carboxylic acid-based functional group

The diene-based rubber (A) that includes a carboxylic acid-based functional group (hereinafter may be referred to as "diene-based rubber (A)") used in connection with one embodiment of the invention is a diene-based rubber that includes a polymer that includes a carboxylic acid-based functional group at the terminal of the main chain and/or in the side chain.

The term "carboxylic acid-based functional group" used herein refers to a carboxyl group or a carboxylic anhydride group.

The term "diene-based rubber" used herein refers to a rubber-like polymer that includes a double bond in the polymer main chain.

The diene-based rubber (A) is not particularly limited as long as the diene-based rubber (A) is a diene-based rubber that includes a carboxylic acid-based functional group.

The average number of carboxylic acid-based functional groups per molecule of the diene-based rubber (A) is normally 1.5 or more, preferably 2 or more, more preferably 1.5 to 20, and still more preferably 2 to 15. When the number of carboxylic acid-based functional groups per molecule of the diene-based rubber (A) is 1.5 or more, it is possible to efficiently form an adhesive layer that exhibits sufficient cohesive strength. It is possible to obtain cohesive strength sufficient for a sealing material when the number of carboxylic acid-based functional groups is within the above range.

Examples of the diene-based rubber (A) include a polybutadiene-based rubber that includes a carboxylic acid-based functional group, a polyisoprene-based rubber that includes a carboxylic acid-based functional group, a copolymer rubber of butadiene and isoprene that includes a carboxylic acid-based functional group, a copolymer rubber of butadiene and n-butene that includes a carboxylic acid-based functional group, and the like. Among these, a polyisoprene-based rubber that includes a carboxylic acid-based functional group is preferable as the diene-based rubber (A) due to a capability to efficiently form an adhesive layer that exhibits sufficient cohesive strength after crosslinking.

These diene-based rubbers may be used either alone or in combination as the diene-based rubber (A).

The diene-based rubber (A) may include a polymer that includes a repeating unit represented by the following formula (I) and a repeating unit represented by the following formula (II).

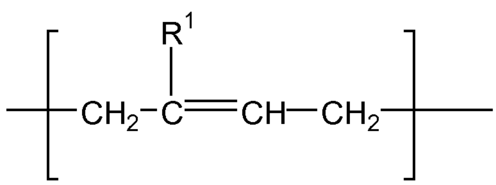

(I)

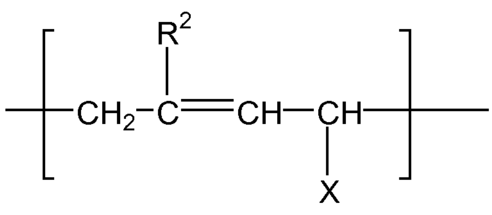

(II)

$R^1$ is a hydrogen atom or an alkyl group having 1 to 5 carbon atoms, and preferably a hydrogen atom or an alkyl group having 1 to 3 carbon atoms.

$R^2$ is a hydrogen atom or an alkyl group having 1 to 5 carbon atoms, and preferably a hydrogen atom or an alkyl group having 1 to 3 carbon atoms.

X is a carboxyl group, a carboxylic anhydride group, or a side chain that includes a carboxyl group or a carboxylic anhydride group. The number of carbon atoms of the side chain is normally 10 or less, and preferably 5 or less.

Examples of the alkyl group having 1 to 5 carbon atoms that may be represented by $R^1$ or $R^2$ include a methyl group, an ethyl group, an n-propyl group, an i-propyl group, an n-butyl group, and the like.

Examples of the group or the side chain that may be represented by X include a group or a side chain represented by the following formula (III) or (IV).

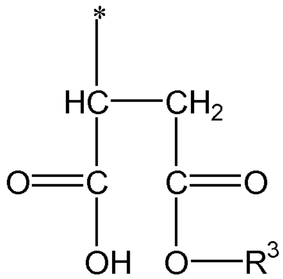

(III)

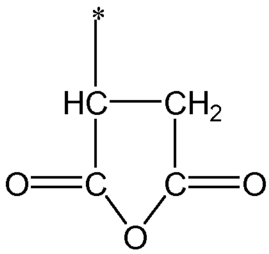

(IV)

$R^3$ is a hydrogen atom or an alkyl group having 1 to 5 carbon atoms, and preferably an alkyl group having 1 to 3 carbon atoms. Specific examples of the alkyl group include those mentioned above in connection with the alkyl group that may be represented by $R^1$ and $R^2$. "*" is the bonding position.

The polymer that includes the repeating unit represented by the formula (I) and the repeating unit represented by the formula (II) may include only one type of the repeating unit represented by the formula (I), or may include two or more types of the repeating unit represented by the formula (I). The polymer may include only one type of the repeating unit represented by the formula (II), or may include two or more types of the repeating unit represented by the formula (II).

The polymer may include a repeating unit derived from another copolymerizable monomer as long as the advantageous effects of the invention are not impaired.

The diene-based rubber (A) may not be hydrogenated (i.e., an unhydrogenated diene-based rubber that includes a carboxylic acid-based functional group), or may be hydrogenated (i.e., a hydrogenated diene-based rubber that includes a carboxylic acid-based functional group).

It is preferable that the diene-based rubber (A) be liquid at room temperature (25°C), but become solid and exhibit rubber elasticity upon crosslinking (i.e., liquid rubber). When the diene-based rubber (A) is a liquid rubber, it is possible to efficiently form an adhesive layer that exhibits sufficient cohesive strength.

The number average molecular weight of the diene-based rubber (A) is preferably 1000 to 100,000, more preferably 5000 to 100,000, and still more preferably 10,000 to 60,000. When the number average molecular weight of the diene-based rubber (A) is 1000 or more, it is possible to prevent a situation in which the diene-based rubber (A) bleeds out from the resulting adhesive layer. When the number average molecular weight of the diene-based rubber (A) is 100,000 or less, the diene-based rubber (A) is sufficiently mixed with the other component(s) when preparing the adhesive composition, and it is possible to efficiently form an adhesive layer that exhibits sufficient cohesive strength.

Note that the number average molecular weight of the diene-based rubber (A) refers to a standard polystyrene-reduced value (standard polystyrene-equivalent value) determined by gel permeation chromatography using tetrahydrofuran as a solvent.

The diene-based rubber (A) may be produced by a method that effects a copolymerization reaction using a monomer that includes a carboxyl group, or a method disclosed in JP-A-2009-29976 that adds maleic anhydride to a polymer such as polybutadiene, for example.

A commercially available product may be used as the diene-based rubber (A). Examples of a commercially available product that may be used as the diene-based rubber (A) include Kuraprene LIR403 (manufactured by Kuraray

Co., Ltd.), Kuraprene LIR410 (manufactured by Kuraray Co., Ltd.), and the like.

The content of the diene-based rubber (A) in the adhesive composition is preferably 0.5 to 95.5 mass%, more preferably 1.0 to 50 mass%, and still more preferably 2.0 to 20 mass%. When the content of the diene-based rubber (A) in the adhesive composition is 0.5 mass% or more, it is possible to efficiently form an adhesive layer that exhibits sufficient cohesive strength. When the content of the diene-based rubber (A) in the adhesive composition is not too high, it is possible to efficiently form an adhesive layer that exhibits sufficient adhesion.

Crosslinking agent (B)

The crosslinking agent (B) used in connection with one embodiment of the invention is a compound that can react with the carboxylic acid-based functional group included in the diene-based rubber (A) to form a crosslinked structure.

Examples of the crosslinking agent (B) include an isocyanate-based crosslinking agent, an epoxy-based crosslinking agent, an aziridine-based crosslinking agent, a metal chelate-based crosslinking agent, and the like.

The isocyanate-based crosslinking agent is a compound that includes an isocyanate group as a crosslinkable group.

Examples of the isocyanate-based crosslinking agent include an aromatic polyisocyanate such as tolylene diisocyanate, diphenylmethane diisocyanate, and xylylene diisocyanate; an aliphatic polyisocyanate such as hexamethylene diisocyanate; an alicyclic polyisocyanate such as isophorone diisocyanate and hydrogenated diphenylmethane diisocyanate; biuret products, isocyanurate products, and adducts (i.e., reaction products with a low-molecular-weight active hydrogen-containing compound (e.g., ethylene glycol, propylene glycol, neopentyl glycol, trimethylolpropane, or castor oil)) thereof; and the like.

The epoxy-based crosslinking agent is a compound that includes an epoxy group as a crosslinkable group.

Examples of the epoxy-based crosslinking agent include 1,3-bis(N,N'-diglycidylaminomethyl)cyclohexane, N,N,N',N'-tetraglycidyl-m-xylylenediamine, ethylene glycol diglycidyl ether, 1,6-hexanediol diglycidyl ether, trimethylolpropane diglycidyl ether, diglycidylaniline, diglycidyl amine, and the like.

The aziridine-based crosslinking agent is a compound that includes an aziridine group as a crosslinkable group.

Examples of the aziridine-based crosslinking agent include diphenylmethane-4,4'-bis(1-aziridinecarboxamide), trimethylolpropane-tri-β-aziridinylpropionate, tetramethylolmethane-tri-β-aziridinylpropionate, toluene-2,4-bis(1-aziridinecarboxamide), triethylenemelamine, bisisophthaloyl-1-(2-methylaziridine), tris-1-(2-methylaziridine)phosphine, trimethylolpropane-tri-β-(2-methylaziridine)propionate, and the like.

Examples of the metal chelate-based crosslinking agent include a chelate compound wherein the metal atom is aluminum, zirconium, titanium, zinc, iron, tin, or the like. It is preferable to use an aluminum chelate compound.

Examples of the aluminum chelate compound include diisopropoxyaluminum monooleyl acetoacetate, monoisopropoxyaluminum bisoleyl acetoacetate, monoisopropoxyaluminum monooleate monoethyl acetoacetate, diisopropoxyaluminum monolauryl acetoacetate, diisopropoxyaluminum monostearyl acetoacetate, diisopropoxyaluminum monoisostearyl acetoacetate, and the like.

It is preferable to use the epoxy-based crosslinking agent as the crosslinking agent (B) since the epoxy-based crosslinking agent has high reactivity with the carboxylic acid-based functional group included in the diene-based rubber (A), and a crosslinked structure can be efficiently formed. When the crosslinking agent (B) is the epoxy-based crosslinking agent, it is possible to efficiently form an adhesive layer that exhibits sufficient cohesive strength, and is preferable as a material for forming a sealing material for an electronic device.

These crosslinking agents may be used either alone or in combination as the crosslinking agent (B).

The crosslinking agent (B) is preferably used in such an amount that the amount of the crosslinkable group included in the crosslinking agent (B) (or the metal chelate-based crosslinking agent when using the metal chelate-based crosslinking agent) is 0.1 to 5 equivalents, and more preferably 0.2 to 3 equivalents, based on the carboxylic acid-based functional groups included in the diene-based rubber (A). When the amount of the crosslinkable group is within the above range, it is possible to efficiently form an adhesive layer that exhibits sufficient cohesive strength.

Rubber-based polymer (C) that does not include carboxylic acid-based functional group

The adhesive composition according to one embodiment of the invention may include a rubber-based polymer (C) that does not include a carboxylic acid-based functional group (hereinafter may be referred to as "rubber-based polymer (C)").

The term "rubber-based polymer" used herein refers to a resin that exhibits rubber elasticity at 25°C.

When the adhesive composition includes the rubber-based polymer (C), it is possible to form a complex and dense structure (i.e., interpenetrating polymer network structure) in which the rubber-based polymer (C) is intertwined with a crosslinked structure that is formed by the reaction between the diene-based rubber (A) and the crosslinking agent

(B), and efficiently form an adhesive layer that exhibits a high water barrier capability and sufficient adhesion. When the adhesive composition includes the rubber-based polymer (C), it is possible to efficiently form an adhesive layer that exhibits adhesion and holding power in a well-balanced manner, and exhibits a high water barrier capability and sufficient cohesive strength. Therefore, it is preferable that the adhesive composition according to one embodiment of the invention include the rubber-based polymer (C).

It is preferable that the rubber-based polymer (C) be rubber that includes a polymethylene-type saturated main chain, or rubber that includes an unsaturated carbon-carbon bond in the main chain.

Specific examples of the rubber-based polymer (C) include an isobutylene homopolymer (polyisobutylene (IM)), a copolymer of isobutylene and n-butene, natural rubber (NR), a butadiene homopolymer (butadiene rubber (BR)), a chloroprene homopolymer (chloroprene rubber (CR)), an isoprene homopolymer (isoprene rubber (IR)), a copolymer of isobutylene and butadiene, a copolymer of isobutylene and isoprene (butyl rubber (IIR)), a halogenated butyl rubber, a copolymer of styrene and 1,3-butadiene (styrene-butadiene rubber (SBR)), a copolymer of acrylonitrile and 1,3-butadiene (nitrile rubber), a styrene-1,3-butadiene-styrene block copolymer (SBS), a styrene-isoprene-styrene block copolymer (SIS), an ethylene-propylene-nonconjugated diene ternary copolymer, and the like.

Among these, an isobutylene-based polymer such as an isobutylene homopolymer, a copolymer of isobutylene and n-butene, a copolymer of isobutylene and butadiene, and a copolymer of isobutylene and isoprene is preferable, and a copolymer of isobutylene and isoprene is more preferable as the rubber-based polymer (C), due to an excellent water barrier capability, high compatibility with the diene-based rubber (A), and a capability to easily form a uniform adhesive layer.

These rubber-based polymers may be used either alone or in combination as the rubber-based polymer (C).

The number average molecular weight of the rubber-based polymer (C) is preferably 100,000 to 2,000,000, more preferably 100,000 to 1,500,000, and still more preferably 100,000 to 1,000,000.

It is possible to prepare an adhesive composition having moderate fluidity, and easily form an adhesive layer that exhibits sufficient adhesion by utilizing the rubber-based polymer (C) having a number average molecular weight of 100,000 or more. When the rubber-based polymer (C) has a number average molecular weight of 2,000,000 or less, the rubber-based polymer (C) is easily dissolved in a normal organic solvent, and it is possible to efficiently prepare the adhesive composition.

Note that the number average molecular weight of the rubber-based polymer (C) refers to a standard polystyrene-reduced value (standard polystyrene-equivalent value) determined by gel permeation chromatography using tetrahydrofuran as a solvent.

The rubber-based polymer (C) may be produced using a known method such as a method that polymerizes the monomer in the presence of a Lewis acid catalyst such as aluminum chloride or boron trifluoride.

A commercially available product may also be used as the rubber-based polymer (C). Examples of a commercially available product that may be used as the rubber-based polymer (C) include Exxon Butyl (manufactured by Japan Butyl Co., Ltd.), Vistanex (manufactured by Exxon Chemical Co.), Hycar (manufactured by Goodrich), Oppanol (manufactured by BASF), and the like.

When using the rubber-based polymer (C), the content of the rubber-based polymer (C) in the adhesive composition is preferably 0.1 to 99.5 mass%, more preferably 10 to 99.5 mass%, still more preferably 50 to 99.0 mass%, and particularly preferably 80 to 98.0 mass%.

Tackifier (D)

The adhesive composition according to one embodiment of the invention may include a tackifier (D).

It is possible to efficiently form an adhesive layer that exhibits further improved adhesion by utilizing the adhesive composition that includes the tackifier (D).

The tackifier (D) is not particularly limited as long as the tackifier (D) improves the adhesion of the adhesive layer. A known tackifier may be used as the tackifier (D). Examples of the tackifier (D) include an alicyclic petroleum resin, an aliphatic petroleum resin, a terpene resin, an ester-based resin, a coumarone-indene resin, a rosin-based resin, an epoxy resin, a phenol resin, an acrylic resin, a butyral resin, an olefin resin, a chlorinated olefin resin, a vinyl acetate resin, modified resins or hydrogenated resins thereof, and the like. Among these, an alicyclic petroleum resin, an aliphatic petroleum resin, a terpene resin, and an ester-based resin are preferable. A hydrogenated resin is preferable as the tackifier (D) since an adhesive layer that is rarely discolored even at a high temperature and a high humidity can be formed. The hydrogenated resin may be a partially hydrogenated product, or may be a completely hydrogenated product.

These tackifiers may be used either alone or in combination as the tackifier (D).

The molecular weight (Mw) of the tackifier (D) is preferably 100 to 10,000, and more preferably 500 to 5000.

The softening point of the tackifier (D) is preferably 50 to 160°C, more preferably 60 to 140°C, and still more preferably 70 to 130°C.

When the softening point of the tackifier (D) is 50°C or more, it is possible to efficiently form an adhesive layer

that exhibits adhesion and holding power in a well-balanced manner.

A commercially available product may also be used as the tackifier (D). Examples of a commercially available product that may be used as the tackifier (D) include an aliphatic petroleum resin such as an ESCOREZ 1000 series (manufactured by Exxon Chemical Co., Ltd.), and a Quintone A/B/R/CX series (manufactured by Zeon Corporation); an alicyclic petroleum resin such as an Arkon P/M series (manufactured by Arakawa Chemical Industries, Ltd.), an ESCOREZ series (manufactured by Exxon Chemical Co., Ltd.), an EASTOTAC series (manufactured by Eastman Chemical Company), and an IMARV series (manufactured by Idemitsu Kosan Co., Ltd.); a terpene-based resin such as a YS resin P/A series (manufactured by Yasuhara Chemical Co., Ltd.), a Clearon P series (manufactured by Yasuhara Chemical Co., Ltd.), and a Piccolyte A/C series (manufactured by Hercules); an ester-based resin such as a Foral series (manufactured by Hercules), a Pensel A series (manufactured by Arakawa Chemical Industries, Ltd.), an Ester Gum series (manufactured by Arakawa Chemical Industries, Ltd.), a Super Ester series (manufactured by Arakawa Chemical Industries, Ltd.), and a Pinecrystal series (manufactured by Arakawa Chemical Industries, Ltd.); and the like.

When using the tackifier (D), the tackifier (D) is normally used in an amount of 5 to 70 parts by mass, preferably 10 to 60 parts by mass, and more preferably 10 to 50 parts by mass, based on 100 parts by mass of the diene-based rubber (A) and the rubber-based polymer (C) in total. When the tackifier (D) is used in an amount of 5 parts by mass or more based on 100 parts by mass of the diene-based rubber (A) and the rubber-based polymer (C) in total, it is possible to efficiently form an adhesive layer that exhibits further improved adhesion. When the tackifier (D) is used in an amount of 70 parts by mass or less based on 100 parts by mass of the diene-based rubber (A) and the rubber-based polymer (C) in total, it is possible to prevent a situation in which the cohesive strength of the adhesive layer decreases.

Additional component

The adhesive composition according to one embodiment of the invention may include an additional component as long as the advantageous effects of the invention are not impaired.

Examples of the additional component include additives such as a light stabilizer, a silane coupling agent, an antistatic agent, an antioxidant, a UV absorber, a resin stabilizer, a filler, a pigment, an extender, and a softener.

These additives may be used either alone or in combination.

The content of each additional component in the adhesive composition is preferably 0.01 to 5 mass%, and more preferably 0.01 to 2 mass%.

Adhesive composition

The adhesive composition according to one embodiment of the invention may be prepared by appropriately mixing and stirring the diene-based rubber (A), the crosslinking agent (B), the rubber-based polymer (C) (optional), the tackifier (D) (optional), an optional additional component, a solvent, and the like using a normal method.

Examples of the solvent include an aromatic hydrocarbon-based solvent such as benzene and toluene; an ester-based solvent such as ethyl acetate and butyl acetate; a ketone-based solvent such as acetone, methyl ethyl ketone, and methyl isobutyl ketone; an aliphatic hydrocarbon-based solvent such as n-pentane, n-hexane, and n-heptane; an alicyclic hydrocarbon-based solvent such as cyclopentane and cyclohexane; and the like.

These solvents may be used either alone or in combination.

The solid content in the adhesive composition according to one embodiment of the invention is preferably 10 to 60 mass%, more preferably 10 to 45 mass%, and still more preferably 15 to 30 mass%.

An adhesive layer obtained by crosslinking the adhesive composition according to one embodiment of the invention exhibits an excellent water barrier capability. Specifically, the adhesive layer having a thickness of 60 $\mu$m has a water vapor transmission rate at a temperature of 40°C and a relative humidity of 90% of 60 g/($m^2$·day) or less, preferably 10 g/($m^2$·day) or less, still more preferably 6 g/($m^2$·day) or less, and yet more preferably 3 g/($m^2$·day) or less.

The water vapor transmission rate of the adhesive layer can be controlled by adjusting the number of carboxylic acid-based functional groups included in the diene-based rubber (A), the amount of the diene-based rubber (A), the amount of the crosslinking agent (B), and the like.

The water vapor transmission rate of the adhesive layer may be measured using the method described later in connection with the examples. Since the water vapor transmission rate of the adhesive layer depends on the thickness of the adhesive layer, the water vapor transmission rate of the adhesive layer is converted using the thickness of the adhesive layer when the thickness of the adhesive layer is not 60 $\mu$m. For example, when the thickness of the adhesive layer is A $\mu$m, and the water vapor transmission rate of the adhesive layer is B g/($m^2$·day), the water vapor transmission rate of the adhesive layer is converted using the expression "A$\times$B/60".

2) Adhesive sheet

An adhesive sheet according to one embodiment of the invention includes an adhesive layer that is formed using the adhesive composition according to one embodiment of the invention. Specific examples of the adhesive sheet according to one embodiment of the invention include an adhesive sheet (α) and an adhesive sheet (β) (see below).
Adhesive sheet (α): An adhesive sheet including an adhesive layer that is formed using the adhesive composition according to one embodiment of the invention, and a release sheet that is provided on one side or each side of the adhesive layer
Adhesive sheet (β): An adhesive sheet including an adhesive layer that is formed using the adhesive composition according to one embodiment of the invention, and a base sheet

Adhesive layer

The adhesive layer included in the adhesive sheet (α) and the adhesive layer included in the adhesive sheet (β) are formed using the adhesive composition according to one embodiment of the invention.
Since the adhesive layer is formed by the reaction between the diene-based rubber (A) and the crosslinking agent (B), the adhesive layer exhibits sufficient cohesive strength and an excellent water barrier capability.
When the adhesive layer is formed using the adhesive composition according to one embodiment of the invention that further includes the rubber-based polymer (C), the adhesive layer has a complex and dense structure (i.e., interpenetrating polymer network structure) in which the polymer molecules of the rubber-based polymer (C) are intertwined with a crosslinked structure that is formed by the reaction between the diene-based rubber (A) and the crosslinking agent (B).
Since the adhesive layer having such a structure exhibits sufficient cohesive strength as described later, the adhesive layer exhibits a further improved water barrier capability, and exhibits adhesion and holding power in a well-balanced manner.
It is preferable to form the adhesive sheet according to one embodiment of the invention using the adhesive composition that includes the rubber-based polymer (C) since these advantageous effects can be easily obtained.
The adhesive layer may be formed using an arbitrary method. For example, the adhesive layer may be formed by applying the adhesive composition according to one embodiment of the invention to the surface of the release layer of the release sheet, or the base sheet, using a known method, and drying the resulting film.
The adhesive composition may be applied using a spin coating method, a spray coating method, a bar coating method, a knife coating method, a roll coating method, a blade coating method, a die coating method, a gravure coating method, or the like.
The film is dried at 80 to 150°C for 30 seconds to 5 minutes, for example.
The dried film may be allowed to stand for about 1 week to cure the adhesive layer. The crosslinked structure can be sufficiently formed by curing the adhesive layer.
The thickness of the adhesive layer is not particularly limited, and may be appropriately determined taking account of the application. The thickness of the adhesive layer is preferably 0.5 to 200 μm, more preferably 1 to 100 μm, and still more preferably 5 to 80 μm. When the thickness of the adhesive layer is 0.5 μm or more, further improved adhesion can be easily obtained. When the thickness of the adhesive layer is 200 μm or less, it is possible to form the adhesive layer with high productivity.
The adhesive layer exhibits an excellent water barrier capability, and exhibits adhesion and holding power in a well-balanced manner. Therefore, when the adhesive layer is used as a sealing material, it is possible to sufficiently prevent entry of water. Since the sealing material is not easily separated (delaminated) at the bonding interface even when heat or vibrations occur when the device is driven, it is possible to prevent entry of water and the like for a long time.
Whether or not the adhesive layer exhibits an excellent water barrier capability is determined by measuring the water vapor transmission rate of the adhesive layer (see above).
Whether or not the adhesive layer exhibits excellent adhesion is determined by measuring the adhesion of the adhesive layer.
For example, when the adhesive sheet is bonded to an adherend at 23°C and 50%RH (relative humidity), and the adhesion of the adhesive layer is measured after allowing the laminate to stand for 24 hours, the adhesion of the adhesive layer is preferably 1 N/25 mm or more when the adherend is a polyethylene terephthalate film, and 1 N/25 mm or more when the adherend is a glass sheet.
Whether or not the adhesive layer exhibits excellent cohesive strength is determined by measuring the holding power of the adhesive layer.
For example, when the adhesive sheet is bonded to a stainless steel sheet (SUS380) so that the bonding area is 25×25 mm to prepare a specimen, and the holding power of the adhesive sheet is measured in accordance with JIS Z 0237 (40°C, dry conditions, load: 9.8 N) using the resulting specimen, it is preferable that the adhesive sheet does

not come off from the stainless steel sheet during a period of 70,000 seconds.

The adhesion and the holding power of the adhesive layer may be measured using the methods described later in connection with the examples.

When the adhesive sheet according to one embodiment of the invention does not include the base sheet (e.g., the adhesive sheets (1a) and (1b) described below), it is preferable that the adhesion and the holding power measured using a specimen prepared by lining the adhesive sheet with a polyethylene terephthalate film or the like be within the above ranges.

Adhesive sheet (α)

FIG. 1 illustrates examples of the adhesive sheet (α) according to one embodiment of the invention (see (a) and (b)).

The adhesive sheet (1a) illustrated in FIG. 1 (see (a)) includes an adhesive layer (2a) that is formed using the adhesive composition according to one embodiment of the invention, and a release sheet (3a) that is provided on one side of the adhesive layer (2a).

The adhesive sheet (1b) illustrated in FIG. 1 (see (b)) includes an adhesive layer (2b) that is formed using the adhesive composition according to one embodiment of the invention, and release sheets (3b) and (3c) that are provided on either side of the adhesive layer (2b).

The release sheet included in the adhesive sheet (α) is not particularly limited. For example, a release sheet that includes a base, and a release layer that is provided on the base, may be used.

Examples of the base used to produce the release sheet include a paper base such as glassine paper, coated paper, and high-quality paper; laminated paper obtained by laminating a thermoplastic resin (e.g., polyethylene) on such a paper base; a plastic film formed of a polyethylene terephthalate resin, a polybutyrene terephthalate resin, a polyethylene naphthalate resin, a polypropylene resin, a polyethylene resin, or the like; and the like.

Examples of a release agent include a silicone-based resin, an olefin-based resin, a rubber-based elastomer (e.g., isoprene-based resin and butadiene-based resin), a long-chain alkyl-based resin, an alkyd-based resin, a fluorine-based resin, and the like.

The thickness of the release sheet is not particularly limited, but is normally 20 to 200 μm, and preferably 25 to 150 μm.

The release sheet may be a double-sided release sheet in which the release layer is formed on each side of the base, or may be a single-sided release sheet in which the release layer is formed on one side of the base. It is preferable to use the double-sided release sheet when producing the adhesive sheet (1a). The adhesive sheet (1a) can be wound in the shape of a roll, and stored when the double-sided release sheet is used.

The adhesive sheet (1a) can be obtained by forming the adhesive layer on a first release sheet using the above method.

The adhesive sheet (1b) can be obtained by bonding a second release sheet to the surface of the adhesive layer of the adhesive sheet (1a).

The second release sheet may be either identical with or different from the first release sheet. It is preferable that the second release sheet require a peel force differing from that of the first release sheet from the viewpoint of workability when removing (peeling) the release sheet.

Since the adhesive layer included in the adhesive sheet (α) exhibits an excellent water barrier capability, and exhibits adhesion and holding power in a well-balanced manner, the adhesive sheet (α) is preferably used to form a sealing material for an electronic device.

Examples of the electronic device include an organic device such as an organic transistor, an organic memory, and an organic EL device, a liquid crystal display, electronic paper, a thin film transistor, an electrochromic device, an electrochemical light-emitting device, a touch panel, a solar cell, a thermoelectric conversion device, a piezoelectric conversion device, an electrical storage device, and the like. Among these, an organic EL device and electronic paper are preferable since it is possible to take full advantage of the characteristics of the adhesive layer.

When forming a sealing material for an electronic device using the adhesive sheet (α), the adhesive layer of the adhesive sheet (α) is bonded to an adherend (e.g., the electrode of an organic EL device), the release sheet is removed, and the adhesive layer is bonded to another adherend so that the adhesive layer that exhibits excellent adhesion to the adherend and an excellent water barrier capability, and functions as a sealing material is provided on the surface of the adherend, for example.

The adhesive sheet (α) may preferably be used as a material for producing the adhesive sheet (β) (described below).

Adhesive sheet (β)

FIG. 2 illustrates examples of the adhesive sheet (β) according to one embodiment of the invention (see (a) and (b)).

The adhesive sheet (1c) illustrated in FIG. 2 (see (a)) includes an adhesive layer (2c) that is formed using the adhesive composition according to one embodiment of the invention, and a base sheet (4a).

The adhesive sheet (1d) illustrated in FIG. 2 (see (b)) includes an adhesive layer (2d) that is formed using the adhesive composition according to one embodiment of the invention, a base sheet (4b), and a release sheet (3d).

The base sheet included in the adhesive sheet (β) is not particularly limited as long as the base sheet can support the adhesive layer.

A film or a sheet formed of a resin (e.g., polyimide, polyamide, polyamide-imide, polyphenylene ether, polyether ketone, polyether ether ketone, polyolefin, polyester (e.g., polyethylene terephthalate), polycarbonate, polysulfone, polyether sulfone, polyphenylene sulfide, polyarylate, acrylic-based resin, cycloolefin-based polymer, aromatic-based polymer, or polyurethane-based polymer), a metal foil (e.g., aluminum foil), a laminate thereof, or the like may be used as the base sheet.

The thickness of the base sheet is not particularly limited, but is preferably 0.5 to 500 μm, more preferably 1 to 200 μm, and still more preferably 5 to 100 μm, from the viewpoint of ease of handling.

The base sheet may include a UV absorber, a light stabilizer, an antioxidant, an antistatic agent, a slipping agent, an antiblocking agent, a coloring agent, and the like. The surface of the base sheet may optionally be subjected to a surface treatment in order to improve adhesion between the base sheet and the adhesive layer.

A gas barrier layer may be formed on the base sheet either directly or through an additional layer in order to provide the base sheet with a gas barrier capability.

The thickness of the gas barrier layer is not particularly limited, but is normally 10 to 2000 nm, preferably 20 to 1000 nm, more preferably 30 to 500 nm, and still more preferably 40 to 200 nm, from the viewpoint of gas barrier capability and handling capability.

The gas barrier layer may include a single layer, or may include a plurality of layers. It is preferable that the gas barrier layer include a plurality of layers since a higher gas barrier capability can be obtained.

A material for forming the gas barrier layer and the like are not particularly limited as long as it is possible to provide the gas barrier layer with the desired gas barrier capability. Examples of the gas barrier layer include an inorganic film, a gas barrier layer obtained by implanting ions into a layer that includes a polymer compound, a metal film (e.g., aluminum film), and the like.

It is preferable that the gas barrier layer be a gas barrier layer that is formed of an inorganic film, or a gas barrier layer obtained by implanting ions into a layer that includes a polymer compound, since it is possible to efficiently form a layer that is thin, and exhibits an excellent gas barrier capability.

The inorganic film is not particularly limited. Examples of the inorganic film include an inorganic deposited film.

Examples of the inorganic deposited film include an inorganic deposited film obtained by depositing an inorganic compound, and an inorganic deposited film obtained by depositing a metal.

Examples of the inorganic compound used as the raw material for forming the inorganic deposited film include an inorganic oxide such as silicon oxide, aluminum oxide, magnesium oxide, zinc oxide, indium oxide, and tin oxide; an inorganic nitride such as silicon nitride, aluminum nitride, and titanium nitride; an inorganic carbide; an inorganic sulfide; an inorganic oxynitride such as silicon oxynitride; an inorganic oxycarbide; an inorganic carbonitride; an inorganic oxycarbonitride; and the like.

Examples of the metal used as the raw material for forming the inorganic deposited film include aluminum, magnesium, zinc, tin, and the like.

These materials may be used either alone or in combination.

An inorganic deposited film that is formed using an inorganic oxide, an inorganic nitride, or a metal as the raw material is preferable from the viewpoint of gas barrier capability. An inorganic deposited film that is formed using an inorganic oxide or an inorganic nitride as the raw material is preferable from the viewpoint of transparency.

The inorganic deposited film may be formed using a physical vapor deposition (PVD) method such as a vacuum deposition method, a sputtering method, or an ion plating method, or a chemical vapor deposition (CVD) method such as a thermal CVD method, a plasma CVD method, or a photo-CVD method, for example.

Examples of the polymer compound used when forming the gas barrier layer by implanting ions into the layer that includes the polymer compound (hereinafter may be referred to as "polymer layer") include a silicon-containing polymer compound (e.g., polyorganosiloxane and polysilazane-based compound), a polyimide, a polyamide, a polyamide-imide, a polyphenylene ether, a polyether ketone, a polyether ether ketone, a polyolefin, a polyester, a polycarbonate, a polysulfone, a polyether sulfone, a polyphenylene sulfide, a polyallylate, an acrylic-based resin, a cycloolefin-based polymer, an aromatic polymer, and the like. These polymer compounds may be used either alone or in combination.

Among these, a polysilazane-based compound is preferable since a gas barrier layer that exhibits an excellent

gas barrier capability can be formed. A product commercially available as a glass coating material or the like may be used directly as the polysilazane-based compound.

The polysilazane-based compounds may be used either alone or in combination.

The polymer layer may include an additional component other than the polymer compound as long as the object of the invention is not impaired. Examples of the additional component include a curing agent, an additional polymer, an aging preventive, a light stabilizer, a flame retardant, and the like.

The polymer layer may be formed by applying a layer-forming solution that includes at least one polymer compound, an optional additional component, a solvent, and the like using a known device (e.g., spin coater, knife coater, or gravure coater), and moderately drying the resulting film, for example.

Examples of the ions implanted into the polymer layer include ions of a rare gas such as argon, helium, neon, krypton, and xenon; ions of a fluorocarbon, hydrogen, nitrogen, oxygen, carbon dioxide, chlorine, fluorine, sulfur, and the like; ions of an alkane-based gas such as methane and ethane; ions of an alkene-based gas such as ethylene and propylene; ions of an alkadiene-based gas such as pentadiene and butadiene; ions of an alkyne-based gas such as acetylene; ions of an aromatic hydrocarbon-based gas such as benzene and toluene; ions of a cycloalkane-based gas such as cyclopropane; ions of a cycloalkene-based gas such as cyclopentene; ions of a metal; ions of an organosilicon compound; and the like.

These ions may be used either alone or in combination.

It is preferable to use ions of a rare gas such as argon, helium, neon, krypton, or xenon due to ease of ion implantation and a capability to form a gas barrier layer that exhibits a particularly excellent gas barrier capability.

The ions may be implanted using an arbitrary method. For example, the ions may be implanted by applying ions (ion beams) accelerated using an electric field, implanting ions present in plasma (plasma ion implantation method), or the like. It is preferable to use the plasma ion implantation method since a gas barrier film can be easily obtained.

The water vapor transmission rate of the gas barrier layer at 40°C and 90%RH is preferably 0.5 g/($m^2$·day) or less, and more preferably 0.05 g/($m^2$·day) or less.

The water vapor transmission rate of the gas barrier layer may be measured using a known gas transmission rate measurement apparatus.

The adhesive sheet (β) may include an additional layer in addition to the adhesive layer and the base sheet. Examples of the additional layer include a protective layer, a conductive layer, a primer layer, a release sheet, and the like. The additional layer may be situated (stacked) at an arbitrary position.

The adhesive sheet (β) can be obtained by forming the adhesive layer on the base sheet using the above method, or producing the adhesive sheet (1a), and bonding the adhesive layer of the adhesive sheet (1a) to the base sheet.

The adhesive layer included in the adhesive sheet (β) exhibits an excellent water barrier capability, and exhibits adhesion and holding power in a well-balanced manner. Therefore, the adhesive sheet (β) exhibits excellent adhesion between the base sheet and the adhesive layer. These characteristics are particularly advantageous when using a gas barrier film that exhibits a very high gas barrier capability as the base sheet. Specifically, since the adhesive sheet (β) suppresses entry of water and the like from the bonding interface between the base sheet and the adhesive layer, the very high performance of the gas barrier film is reflected directly in the adhesive sheet (β).

Therefore, the adhesive sheet (β) may preferably be used to form a sealing material for an electronic device in the same manner as the adhesive sheet (α).

Examples of the electronic device include those mentioned above. In particular, an organic EL device is preferable.

When forming a sealing material for an electronic device using the adhesive sheet (β), the adhesive layer of the adhesive sheet (β) is bonded to an adherend (e.g., the electrode of an organic EL device) so that the sealing material and the base sheet are provided on the surface of the adherend.

The adhesive sheet according to one embodiment of the invention is useful as a material for forming a sealing material for an electronic device (described below).

3) Electronic device

An electronic device according to one embodiment of the invention includes a sealing material, the sealing material being formed using the adhesive composition according to one embodiment of the invention, or the adhesive sheet according to one embodiment of the invention.

Examples of the electronic device include an organic device such as an organic transistor, an organic memory, and an organic EL device, a liquid crystal display, electronic paper, a thin film transistor, an electrochromic device, an electrochemical light-emitting device, a touch panel, a solar cell, a thermoelectric conversion device, a piezoelectric conversion device, an electrical storage device, and the like.

FIG. 3 illustrates the structure of an organic EL device as an example of the electronic device according to one embodiment of the invention.

An organic EL device 10 includes a glass substrate 11, and a structure 12 that is formed on the glass substrate 11. The structure 12 is formed by stacking a transparent electrode, a hole-transporting layer, an emitting layer, a bottom electrode, and the like (not illustrated in FIG. 3). An adhesive sheet 1 that includes an adhesive layer 2 and a base sheet 4 is laminated (stacked) on the structure 12 and the glass substrate 11. In this case, the adhesive composition (or a solution prepared by diluting the adhesive composition with an appropriate solvent) may be applied to the structure 12 and the glass substrate 11, and dried to form the adhesive layer 2, and the base sheet 4 may be laminated (stacked) on the adhesive layer 2.

Since the organic EL device 10 is configured so that the structure 12 is covered with the adhesive layer 2, entry of water and the like is suppressed, and a situation does not occur in which the adhesive layer 2 is displaced or delaminated from the structure 12 due to heat or vibrations that occur when the electronic device is driven. In particular, when a gas barrier film that exhibits an excellent gas barrier capability is used as the base sheet 4, delamination rarely occurs at the interface between the adhesive layer 2 and the gas barrier film (base sheet 4), and it is possible to take full advantage of the performance of the gas barrier film.

## EXAMPLES

The invention is further described below by way of examples. Note that the invention is not limited to the following examples.

Note that the units "parts" and "%" used in connection with the examples respectively refer to "parts by mass" and "mass%" unless otherwise indicated.

### Compound

The compounds and the materials shown below were used in the examples. Diene-based rubber (A1) that includes carboxylic acid-based functional group: polyisoprene-based rubber that includes a carboxylic acid-based functional group that is represented by the following formula (V) ("LIR410" manufactured by Kuraray Co., Ltd., number average molecular weight: 30,000, number of carboxylic acid-based functional groups per molecule: 10 ("Diene-based rubber (A1)" in Tables 1 and 2))

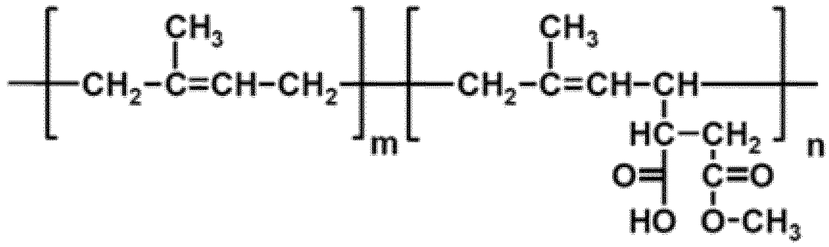

· · · (V)

Diene-based rubber (A2) that includes carboxylic acid-based functional group: polyisoprene-based rubber that includes a carboxylic acid-based functional group that is represented by the following formula (VI) ("LIR403" manufactured by Kuraray Co., Ltd., number average molecular weight: 25,000, number of carboxylic acid-based functional groups per molecule: 3 ("Diene-based rubber (A2)" in Table 3))

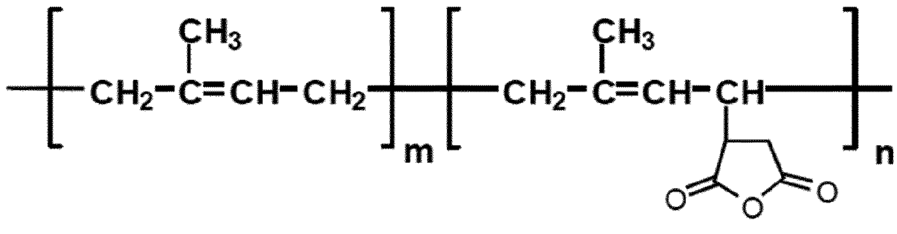

· · · (VI)

Rubber-based polymer (C1) that does not include carboxylic acid-based functional group: copolymer of isobutylene and isoprene ("Exxon Butyl 268" manufactured by Japan Butyl Co., Ltd., number average molecular weight: 260,000 ("Rubber-based polymer (C1)" in Tables 1 to 3))

Crosslinking agent (B1): epoxy compound ("TC-5" manufactured by Mitsubishi Chemical Corporation)
Crosslinking agent (B2): aluminum chelate compound ("M-5A" manufactured by Soken Chemical & Engineering Co., Ltd.)
Crosslinking agent (B3): polyisocyanate compound ("L-45" manufactured by Soken Chemical & Engineering Co., Ltd.)
Crosslinking agent (B4): polyisocyanate compound ("Coronate L" manufactured by Nippon Polyurethane Industry Co., Ltd.)
Tackifier (D1): aliphatic petroleum resin ("Quintone A100" manufactured by Zeon Corporation, softening point: 100°C)
Monomer (1): butyl acrylate
Monomer (2): acrylic acid
Initiator (1): azobisisobutyronitrile
Base sheet (1): film in which a polyethylene terephthalate sheet (12 μm) is bonded to each side of an aluminum foil (7 μm) using a urethane-based adhesive layer (manufactured by Asia Alumi Co., Ltd.)
Release sheet (1): easy release sheet (polyethylene terephthalate film subjected to a silicone release treatment) ("SP-PET381130" manufactured by Lintec Corporation, thickness: 38 μm)
Release sheet (2): tight release sheet (polyethylene terephthalate film subjected to a silicone release treatment) ("SP-PET38T103-1" manufactured by Lintec Corporation, thickness: 38 μm)

Note that the average molecular weight of the diene-based rubber (A1), the diene-based rubber (A2), and the rubber-based polymer (C1) was determined as a standard polystyrene-reduced value (standard polystyrene-equivalent value) by performing gel permeation chromatography under the following conditions.

Device: HLC-8020 (manufactured by Tosoh Corporation)
Column: TSK guard column HXL-H, TSK gel GMHXL(×2), TSK gel G2000HXL (manufactured by Tosoh Corporation)
Column temperature: 40°C
Eluant: tetrahydrofuran
Flow rate: 1.0 mL/min

The softening point of the tackifier (D1) was measured in accordance with JIS K 2531.

Example 1

Preparation of adhesive composition

5 parts of the diene-based rubber (A1), 100 parts of the rubber-based polymer (1), and 2 parts of the crosslinking agent (B1) were dissolved in toluene to prepare an adhesive composition (1) having a solid content of 25%.

Production 1 of adhesive sheet

The adhesive composition (1) was applied to the base sheet (1) so that the thickness after drying was 20 μm, and the resulting film was dried at 110°C for 1 minute to form an adhesive layer. The release-treated surface of the release sheet (1) was bonded to the adhesive layer to obtain an adhesive sheet (1A).

Production 2 of adhesive sheet

The adhesive composition (1) was applied to the release-treated surface of the release sheet (2) so that the thickness after drying was 60 μm, and the resulting film was dried at 110°C for 1 minute to form an adhesive layer. The release-treated surface of the release sheet (1) was bonded to the adhesive layer to obtain an adhesive sheet (1B).

Production of organic EL device

An indium tin oxide (ITO) film (thickness: 150 nm, sheet resistance: 30 Ω/sq) was formed on the surface of a glass substrate using a sputtering method, and subjected to a solvent washing treatment and a UV/ozone treatment to form an anode.

N,N'-Bis(naphthalen-1-yl)-N,N'-bis(phenyl)-benzidine) (manufactured by Luminescence Technology) (60 nm), tris(8-hydroxyquinolinato)aluminum (manufactured by Luminescence Technology) (40 nm), 2,9-dimethyl-4,7-diphenyl-1,10-phenanthroline (manufactured by Luminescence Technology) (10 nm), and (8-hydroxyquinolinolato)lithium (manufactured by Luminescence Technology) (10 nm) were sequentially deposited on the anode (ITO film) at a deposition

rate of 0.1 to 0.2 nm/s to form an emitting layer.

Aluminum (Al) (manufactured by Kojundo Chemical Lab. Co., Ltd.) (100 nm) was deposited on the emitting layer at a deposition rate of 0.1 nm/s to form a cathode.

Note that the degree of vacuum during deposition was set to $1\times10^{-4}$ Pa or less.

The adhesive sheet (1A) was heated at 120°C for 30 minutes in a nitrogen atmosphere using a hot plate to remove water included in the adhesive sheet (1A), and allowed to cool to room temperature. After removing the release sheet (1) from the adhesive sheet (1A), the exposed adhesive layer was laminated on the cathode so as to cover the entirety of the cathode to obtain an organic EL device (1).

Examples 2 to 13 and Comparative Examples 1 and 2

Adhesive compositions (2) to (15) were prepared in the same manner as in Example 1, except that each component and the amount of each component were changed as shown in Table 1 or 2, and adhesive sheets (2A) to (15A), adhesive sheets (2B) to (15B), and organic EL devices (2) to (15) were obtained in the same manner as in Example 1, except that the resulting adhesive composition was used.

Comparative Example 3

A reactor was charged with 90 parts of the monomer (1), 10 parts of the monomer (2), and 0.2 parts of the initiator (1), and the components were mixed. The resulting mixture was deaerated by bubbling nitrogen gas for 4 hours, and heated to 60°C with stirring. The mixture was stirred at 60°C for 24 hours to effect a polymerization reaction. The reaction mixture was then diluted with ethyl acetate to obtain an ethyl acetate solution of an acrylic-based copolymer (weight average molecular weight: 650,000) (solid content: 33%).

After the addition of the crosslinking agent (B4) so that the amount of solid was 1.5 parts based on 100 parts of the solid included in the ethyl acetate solution, toluene was added to the mixture to obtain an adhesive composition (16) having a solid content of 20%.

An adhesive sheet (16A), an adhesive sheet (16B), and an organic EL device (16) were obtained in the same manner as in Example 1, except that the adhesive composition (16) was used instead of the adhesive composition (1).

Examples 14 to 26

Adhesive compositions (17) to (29) were prepared in the same manner as in Example 1, except that each component and the amount of each component were changed as shown in Table 3, and adhesive sheets (17A) to (29A), adhesive sheets (17B) to (29B), and organic EL devices (17) to (29) were obtained in the same manner as in Example 1, except that the resulting adhesive composition was used.

The adhesive sheets and the organic EL devices obtained in the examples and the comparative examples were subjected to the following measurements, and evaluated as described below. The measurement results and the evaluation results are shown in Tables 1 to 3.

Measurement of water vapor transmission rate

After removing the release sheets (1) and (2) from the adhesive sheet ((1B) to (29B)), the adhesive sheet was bonded to a polyethylene terephthalate film (manufactured by Mitsubishi Plastics Inc., thickness: 6 μm) to obtain a water vapor transmission rate measurement sample in which the adhesive layer (thickness: 60 μm) was situated between two polyethylene terephthalate films. The water vapor transmission rate (B) of the adhesive layer was measured at 40°C and 90%RH using a water vapor transmission rate measurement apparatus ("L80-5000" manufactured by LYSSY), and the water vapor transmission rate of the adhesive layer when the thickness of the adhesive layer is 60 μm was calculated using the following conversion formula (1).

$$\text{Water vapor transmission rate when thickness is } 60\ \mu\text{m} = A \times B/60 \qquad (1)$$

A: Thickness of adhesive layer
B: Water vapor transmission rate of adhesive layer

Measurement of adhesion

The adhesive sheet ((1A) to (29A)) was cut to dimensions of 25×300 mm. After removing the release sheet (1), the exposed adhesive layer was bonded to an adherend (see below) at 23°C and 50%RH, and the adhesive sheet and the adherend were compression-bonded by reciprocating a roller having a weight of 2 kg by one stroke to obtain a specimen.
After allowing the specimen to stand at 23°C and 50%RH for 24 hours, the specimen was subjected to a peel test at 23°C and 50%RH using a tensile tester ("Tensilon" manufactured by Orientec Co., Ltd.) at a peel rate of 300 mm/min and a peel angle of 180° to measure the adhesion (N/25 mm) of the specimen.
The following adherends were used for the measurement of adhesion. PET film: "Cosmoshine A4100" manufactured by Toyobo Co., Ltd., thickness: 50 μm Glass sheet (soda-lime glass): product manufactured by Nippon Sheet Glass Co., Ltd.

Measurement of holding power

The adhesive sheet ((1A) to (29A)) was cut to dimensions of 25×300 mm. After removing the release sheet (1), the exposed adhesive sheet was bonded to a stainless steel sheet (SUS380) at 23°C and 50%RH so that the bonding area was 25×25 mm, and the adhesive sheet and the stainless steel sheet were compression-bonded by reciprocating a roller having a weight of 2 kg by one stroke to obtain a specimen.
The holding power of the adhesive sheet was measured in accordance with JIS Z 0237 (40°C, load: 9.8 N) using the resulting specimen to determine whether or not the adhesive sheet came off from the stainless steel sheet during a period of 70,000 seconds. In Tables 1 to 3, a case where the adhesive sheet did not come off from the stainless steel sheet is indicated by "NC", and a case where the adhesive sheet came off from the stainless steel sheet is indicated by "C". The value in the parenthesis represents the amount (mm) by which the adhesive sheet came off.

Water entry test

A calcium layer having a length of 32 mm, a width of 40 mm, and a thickness of 100 nm was formed on an alkali-free glass substrate (manufactured by Corning, 45×45 mm) using a vacuum deposition method.
After removing the release sheet (1) from the adhesive sheet ((1A) to (29A)), the exposed adhesive layer was bonded to the calcium layer formed on the glass substrate in a nitrogen atmosphere using a laminator to obtain a water entry test specimen in which the calcium layer was sealed.
The resulting specimen was allowed to stand at 60°C and 90%RH for 170 hours, and the degree of discoloration of the calcium layer (i.e., the degree of entry of water) was observed with the naked eye. The water barrier capability was evaluated in accordance with the following standard.

Evaluation standard

A: Less than 20% (area ratio) of the calcium layer was discolored.
B: 20% or more and less than 40% (area ratio) of the calcium layer was discolored.
C: 40% or more (area ratio) of the calcium layer was discolored.

Evaluation of organic EL device

The organic EL device ((1) to (16)) was allowed to stand at 23°C and 50%RH for 200 hours, and driven to observe the presence or absence of a dark spot (i.e., an area in which light was not emitted). The organic EL device was evaluated in accordance with the following standard.

A: The ratio of a dark spot area was less than 5% with respect to the emission area.

B: The ratio of a dark spot area was 5% or more and less than 10% with respect to the emission area.

C: The ratio of a dark spot area was 10% or more and less than 90% with respect to the emission area.

D: The ratio of a dark spot area was 90% or more with respect to the emission area.

TABLE 1

| | | | Example | | | | | | |
|---|---|---|---|---|---|---|---|---|---|
| | | | 1 | 2 | 3 | 4 | 5 | 6 | 7 |
| Adhesive composition | Diene-based rubber (Al) (parts) | | 5 | 5 | 5 | 5 | 10 | 15 | 20 |
| | Rubber-based polymer (C1) (parts) | | 100 | 100 | 100 | 100 | 100 | 100 | 100 |
| | Crosslinking agent (parts) | Crosslinking agent (B1) | 2 | 2 | - | - | 4 | 6 | 8 |
| | | Crosslinking agent (B2) | - | - | 3 | - | - | - | - |
| | | Crosslinking agent (B3) | - | - | - | 0.3 | - | - | - |
| | Tackifier (D1) (parts) | | - | 20 | 20 | 20 | 20 | 20 | 20 |
| Water vapor transmission rate (g/($m^2$·day)) | | | 2.5 | 2 | 2 | 2.2 | 5.2 | 5.6 | 5.5 |
| Adhesion (N/25 mm) | PET film | | 1.4 | 12 | 10.5 | 9 | 7.2 | 6.8 | 6.2 |
| | Glass sheet | | 1.2 | 7.8 | 6.1 | 7.4 | 4.4 | 3.7 | 2.8 |
| Holding power (mm) | | | NC | NC | NC | NC | NC | C(4) | C(4) |
| Water entry test | | | A | A | A | A | A | A | A |
| Evaluation of organic EL device | | | B | A | A | A | A | A | A |

TABLE 2

| | | | Example | | | | | | Comparative Example | | |
|---|---|---|---|---|---|---|---|---|---|---|---|
| | | | 8 | 9 | 10 | 11 | 12 | 13 | 1 | 2 | 3 |
| Adhesive composition | Diene-based rubber (Al) (parts) | | 100 | 100 | 100 | 100 | 100 | 100 | - | - | - |
| | Rubber-based polymer (C1) (parts) | | - | - | - | - | - | - | 100 | 100 | |
| | Crosslinking agent (parts) | Crosslinking agent (B1) | 40 | - | - | 40 | - | - | - | - | |
| | | Crosslinking agent (B2) | - | 60 | - | - | 60 | - | - | - | |
| | | Crosslinking agent (B3) | - | - | 6 | - | - | 6 | - | - | |
| | Tackifier (D1) (parts) | | - | - | - | 20 | 20 | 20 | - | 20 | |
| Water vapor transmission rate (g/(m$^2$·day)) | | | 54 | 55 | 59 | 54 | 58 | 57 | 2.1 | 3.1 | 98 |
| Adhesion (N/25 mm) | PET film | | 3.5 | 5 | 3.5 | 6.9 | 6.9 | 6.8 | 2.9 | 13.8 | 11.6 |
| | Glass sheet | | 4.7 | 5.2 | 4.8 | 7.2 | 7.1 | 7.2 | 0.6 | 7.2 | 10.2 |
| Holding power (mm) | | | NC | NC | NC | NC | NC | NC | C (6) | C (2) | NC |
| Water entry test | | | B | B | B | A | A | A | B | B | C |
| Evaluation of organic EL device | | | B | B | B | B | B | B | C | C | D |

TABLE 3

| | | Example 14 | 15 | 16 | 17 | 18 | 19 | 20 | 21 | 22 | 23 | 24 | 25 | 26 |
|---|---|---|---|---|---|---|---|---|---|---|---|---|---|---|
| Adhesive composition | Diene-based rubber (A2) (parts) | 5 | 5 | 5 | 5 | 10 | 15 | 20 | 100 | 100 | 100 | 100 | 100 | 100 |
| | Rubber-based polymer (C1) (parts) | 100 | 100 | 100 | 100 | 100 | 100 | 100 | - | - | - | - | - | - |
| | Crosslinking agent (parts): Crosslinking agent (B1) | 1 | 1 | - | - | 2 | 3 | 4 | 20 | - | - | 20 | - | - |
| | Crosslinking agent (parts): Crosslinking agent (B2) | - | - | 1 | - | - | - | - | - | 30 | - | - | 30 | - |
| | Crosslinking agent (parts): Crosslinking agent (B3) | - | - | - | 0.2 | - | - | - | - | - | 3 | - | - | 3 |
| | Tackifier (D1) (parts) | - | 20 | 20 | 20 | 20 | 20 | 20 | - | - | - | 20 | 20 | 20 |
| Water vapor transmission rate (g/(m$^2$·day)) | | 2.4 | 2.3 | 2.3 | 2.6 | 5.3 | 5.8 | 5.9 | 55 | 65 | 66 | 54 | 64 | 65 |
| Adhesion (N/25 mm) | PET film | 1.4 | 12 | 11.5 | 10.2 | 7.5 | 7.2 | 7.2 | 3.5 | 4.2 | 3.5 | 6.9 | 6.8 | 6.8 |
| | Glass sheet | 1.2 | 7.4 | 5.5 | 6.3 | 3.6 | 2.9 | 2.5 | 3.2 | 2.9 | 3.2 | 6.8 | 6.5 | 7 |
| Holding power (mm) | | NC | NC | NC | NC | NC | C (5) | C (5) | NC | NC | NC | NC | NC | NC |
| Water entry test | | A | A | A | A | A | A | A | B | B | B | A | A | A |
| Evaluation of organic EL device | | B | A | A | A | A | A | A | B | B | B | B | B | B |

The following were confirmed from the results shown in Tables 1 to 3.

An adhesive layer that exhibited a good water barrier capability and good holding power, and exhibited adhesion and holding power in a well-balanced manner could be formed using the adhesive compositions of Examples 1 to 26 (see the test results of the adhesive sheets respectively formed using the adhesive compositions of Examples 1 to 26). In particular, the adhesive sheets (1B) to (7B) of Examples 1 to 7 that were formed using the diene-based rubber (A1) and the rubber-based polymer (C1), and the adhesive sheets (17B) to (23B) of Examples 14 to 20 that were formed using the diene-based rubber (A2) and the rubber-based polymer (C1), exhibited a very good water barrier capability.

The adhesive sheets (1A) to (13A) and (17A) to (29A) including the adhesive layer and the gas barrier film exhibited high performance when subjected to the water entry test, and the organic EL devices (1) to (13) respectively including the adhesive sheets (1A) to (13A), and the organic EL devices (17) to (29) respectively including the adhesive sheets (17A) to (29A), exhibited high durability.

In contrast, the adhesive sheet (16B) of Comparative Example 3 that was formed using the acrylic-based adhesive had a high water vapor transmission rate, and the water barrier capability of the adhesive sheet (16A) and the durability of the organic EL device (16) were poor.

The adhesive sheets (14B) and (15B) that were respectively formed using the adhesive compositions of Comparative Examples 1 and 2 had a low water vapor transmission rate, but exhibited low holding power, and the balance between adhesion and holding power was poor. Therefore, it was impossible to take full advantage of the performance of the gas barrier film, and the organic EL devices (14) and (15) exhibited poor durability.

REFERENCE SIGNS LIST

1, 1a, 1b, 1c, 1d: Adhesive sheet
2, 2a, 2b, 2c, 2d: Adhesive layer
3a, 3b, 3c, 3d: Release sheet
4, 4a, 4b: Base sheet
10: Organic EL device
11: Glass substrate
12: Structure

## Claims

1. An adhesive composition comprising a diene-based rubber (A) that includes a carboxylic acid-based functional group, and a crosslinking agent (B), an adhesive layer having a thickness of 60 μm that is obtained by crosslinking the adhesive composition having a water vapor transmission rate at a temperature of 40°C and a relative humidity of 90% of 60 g/($m^2$·day) or less.

2. The adhesive composition according to claim 1, wherein the diene-based rubber (A) is a polyisoprene-based rubber that includes a carboxylic acid-based functional group.

3. The adhesive composition according to claim 1, wherein the diene-based rubber (A) comprises a polymer that comprises a repeating unit represented by a formula (I) and a repeating unit represented by a formula (II),

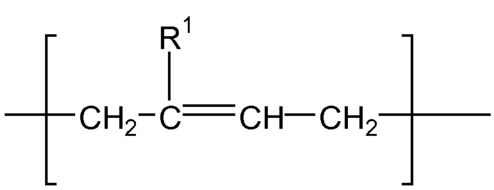

(I)

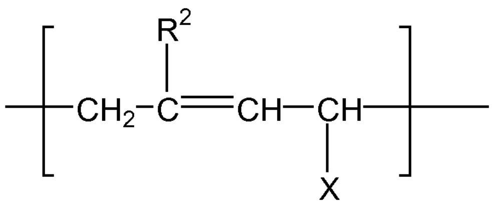

(II)

wherein $R^1$ and $R^2$ are a hydrogen atom or an alkyl group having 1 to 5 carbon atoms, X is a group represented by a formula (III) or (IV),

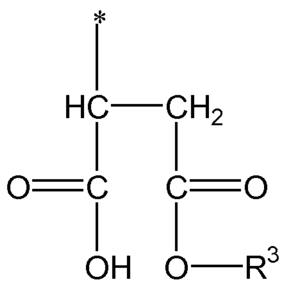

(III)

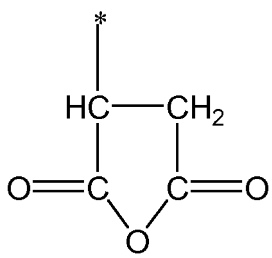

(IV)

$R^3$ is a hydrogen atom or an alkyl group having 1 to 5 carbon atoms, and "*" is a bonding position.

**4.** The adhesive composition according to claim 1, wherein the diene-based rubber (A) has a number average molecular weight (Mn) of 1000 to 100,000.

**5.** The adhesive composition according to claim 1, wherein an average number of carboxylic acid-based functional groups per molecule of the diene-based rubber (A) is 1.5 to 20.

**6.** The adhesive composition according to claim 1, wherein the crosslinking agent (B) is an epoxy-based crosslinking agent.

**7.** The adhesive composition according to claim 1, further comprising a rubber-based polymer (C) that does not include a carboxylic acid-based functional group.

**8.** The adhesive composition according to claim 7, wherein the rubber-based polymer (C) that does not include a carboxylic acid-based functional group is an isobutylene-based polymer.

**9.** The adhesive composition according to claim 1, further comprising a tackifier (D).

**10.** An adhesive sheet comprising an adhesive layer that is formed using the adhesive composition according to any one of claims 1 to 9, and a release sheet that is provided on one side or each side of the adhesive layer.

**11.** An adhesive sheet comprising an adhesive layer that is formed using the adhesive composition according to any one of claims 1 to 9, and a base sheet.

**12.** The adhesive sheet according to claim 10 or 11, wherein the adhesive layer is formed by a reaction between the

diene-based rubber (A) and the crosslinking agent (B).

**13.** The adhesive sheet according to claim 10 or 11, the adhesive sheet being used to form a sealing material for an electronic device.

**14.** An electronic device comprising a sealing material, the sealing material being formed using the adhesive composition according to any one of claims 1 to 9, or the adhesive sheet according to claim 13.

FIG. 1

(a)

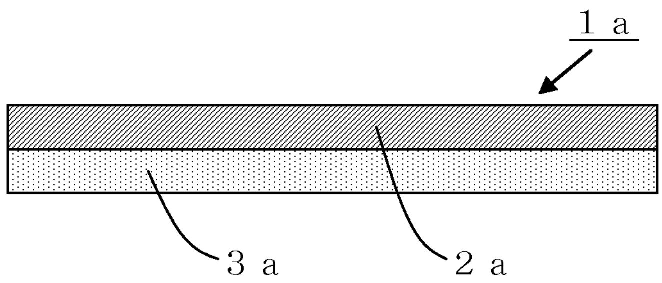


(b)

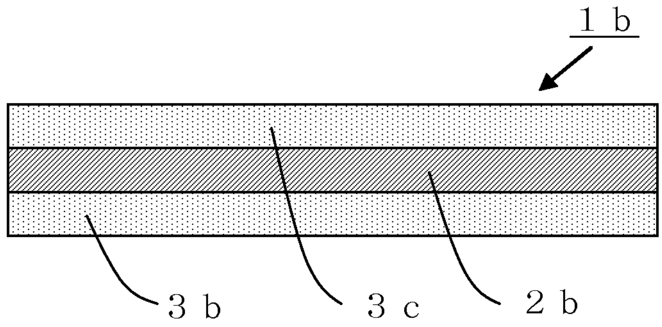

FIG. 2

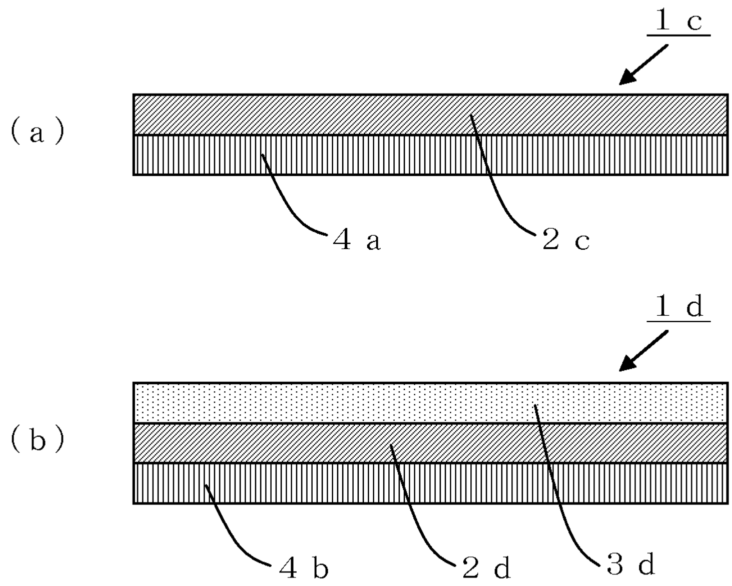


FIG. 3

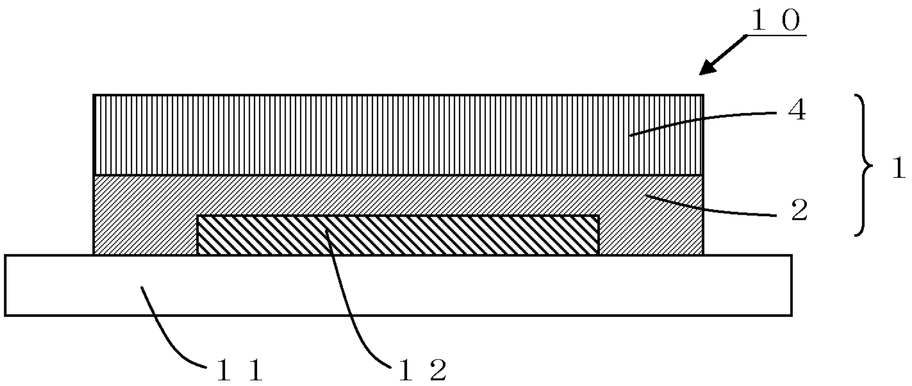

## INTERNATIONAL SEARCH REPORT

International application No.
PCT/JP2013/082171

A. CLASSIFICATION OF SUBJECT MATTER
*C09J113/00*(2006.01)i, *C09J7/02*(2006.01)i, *C09J123/20*(2006.01)i, *H01L21/56* (2006.01)i, *H01L51/50*(2006.01)i, *H05B33/04*(2006.01)i

According to International Patent Classification (IPC) or to both national classification and IPC

B. FIELDS SEARCHED

Minimum documentation searched (classification system followed by classification symbols)
C09J1/00-C09J201/10, H01L21/56, H01L51/50, H05B33/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 02-296821 A (Nippon Oil Co., Ltd.), 07 December 1990 (07.12.1990), claims; page 3, upper right column, lines 6 to 18; examples 1 to 6, 8, 9 (Family: none) | 1-7,14<br>10-13<br>8,9 |
| X<br>Y | WO 2011/062167 A1 (Ajinomoto Co., Inc.), 26 May 2011 (26.05.2011), claims; paragraphs [0019] to [0028], [0068], [0078]; examples & US 2012/0283375 A1 & EP 2502962 A1 & KR 10-2012-0091349 A | 1-14<br>10-13 |
| X<br>A | JP 09-307127 A (Kaneka Corp.), 28 November 1997 (28.11.1997), claims; paragraphs [0017] to [0019], [0036] (Family: none) | 1-9,14<br>10-13 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>14 February, 2014 (14.02.14) | Date of mailing of the international search report<br>25 February, 2014 (25.02.14) |
| Name and mailing address of the ISA/<br>Japanese Patent Office<br>Facsimile No. | Authorized officer<br><br>Telephone No. |

Form PCT/ISA/210 (second sheet) (July 2009)

**INTERNATIONAL SEARCH REPORT**

International application No.
PCT/JP2013/082171

C (Continuation). DOCUMENTS CONSIDERED TO BE RELEVANT

| Category* | Citation of document, with indication, where appropriate, of the relevant passages | Relevant to claim No. |
|---|---|---|
| A | JP 03-252483 A (Sekisui Chemical Co., Ltd.), 11 November 1991 (11.11.1991), (Family: none) | 1-14 |
| A | JP 2004-099651 A (The Yokohama Rubber Co., Ltd.), 02 April 2004 (02.04.2004), (Family: none) | 1-14 |
| A | JP 2011-184639 A (Tomoegawa Paper Co., Ltd.), 22 September 2011 (22.09.2011), (Family: none) | 1-14 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 5182759 A
- JP 5101884 A
- JP 2004087153 A
- JP 2004224991 A
- JP 2009524705 T
- WO 20070087281 A
- JP 2009029976 A